# FASCICULE DE BREVET EUROPEEN

(11) **EP 3 241 246 B1**
(45) Date de publication et mention de la délivrance du brevet: **31.10.2018**
(21) Numéro de dépôt: 15823722.2
(22) Date de dépôt: 24.12.2015
(51) Int. Cl.: H01L 33/00, H01L 33/18, H01L 33/08, H01L 33/44, H01L 33/24, H01L 31/18, H01L 33/40, H01L 33/46

(54) **PROCÉDÉ DE FABRICATION DE NANOFILS OU DE MICROFILS SEMICONDUCTEURS À PIEDS ISOLÉS**
VERFAHREN ZUR HERSTELLUNG VON HALBLEITERNANODRÄHTEN ODER -MIKRODRÄHTEN MIT ISOLIERTER BASIS
PROCESS FOR FABRICATING SEMICONDUCTOR NANOWIRES OR MICROWIRES HAVING INSULATED BASE

(30) Priorité: 29.12.2014 FR 1463372
(43) Date de publication de la demande: 08.11.2017
(73) Titulaire: Aledia, 38040 Grenoble (FR); Commissariat à l'énergie atomique et aux énergies alternatives, 75015 Paris (FR)
(72) Inventeur: POURQUIER, Eric, 38000 Grenoble (FR); GIBERT, Philippe, 38960 St Etienne de Crossey (FR); MARTIN, Brigitte, 38120 Saint Egreve (FR)
(74) Mandataire: Cabinet Beaumont
(86) Numéro de dépôt international: PCT/FR2015/053758
(87) Numéro de publication internationale: WO 2016/108023

(56) Documents cités:
- WO-A1-2014/064276
- WO-A1-2014/064395
- WO-A1-2014/196920

## Description

La présente demande de brevet revendique la priorité de la demande de brevet français FR14/63372.

### Domaine

La présente invention concerne de façon générale les procédés de fabrication de dispositifs électroniques comprenant des microfils ou nanofils en matériau semiconducteur.

### Exposé de l'art antérieur

Les microfils ou les nanofils comprenant un matériau semiconducteur permettent notamment la fabrication de dispositifs optoélectriques. Par dispositifs optoélectroniques, on entend des dispositifs adaptés à effectuer la conversion d'un signal électrique en un rayonnement électromagnétique ou inversement, et notamment des dispositifs dédiés à la détection, la mesure ou l'émission d'un rayonnement électromagnétique ou des dispositifs dédiés à des applications photovoltaïques.

Pour certaines structures dans lesquelles les nanofils ou microfils sont formés sur un support, il est nécessaire de recouvrir d'une couche isolante la portion inférieure de chaque nanofil ou microfil ainsi que le support entre les nanofils ou microfils, la portion supérieure de chaque nanofil ou microfil n'étant pas recouverte par cette couche isolante. Il peut toutefois être difficile de réaliser une isolation uniforme des pieds d'un ensemble de nanofils ou microfils, en particulier d'isoler la portion inférieure de chaque nanofil ou microfil d'une hauteur qui soit sensiblement la même pour tous les microfils et nanofils.

Les documents WO 2014/196920 A1, WO 2014/064276 A1 et WO 2014/064395 A1 décrivent chacun un procédé de fabrication d'un dispositif optoélectronique comportant des nanofils.

### Résumé

Ainsi, un objet d'un mode de réalisation est de pallier au moins en partie les inconvénients des procédés de fabrication des dispositifs électroniques à microfils ou nanofils décrits précédemment.

Un autre objet d'un mode de réalisation est que les hauteurs d'isolation des portions inférieures de nanofils ou microfils d'un ensemble de nanofils ou microfils soient sensiblement égales.

Un autre objet d'un mode de réalisation est que le dispositif électronique puisse être formé à une échelle industrielle et à bas coût.

Ainsi, un mode de réalisation prévoit un procédé de fabrication d'un dispositif électronique comprenant un substrat et des microfils ou nanofils reposant sur le substrat, le procédé comprenant les étapes successives suivantes :
a) recouvrir les microfils ou nanofils d'une couche isolante ;
b) recouvrir la couche isolante d'une couche opaque ;
c) déposer une première couche de résine photosensible s'étendant sur le substrat entre les fils ;
d) graver la première couche de résine photosensible sur une première épaisseur par photolithographie ;
e) graver la première couche de résine photosensible restante après l'étape d) sur une deuxième épaisseur par gravure au plasma ;
f) graver la partie de la couche opaque non recouverte de la première couche de résine photosensible restante après l'étape e) ;
g) graver la partie de la couche isolante non recouverte de la couche opaque ;
h) retirer la première couche de résine photosensible restante après l'étape e) ; et
i) retirer la couche opaque.

Selon un mode de réalisation, la hauteur des microfils ou nanofils est comprise entre 250 nm et 50 µm.

Selon un mode de réalisation, l'épaisseur maximale de la première couche de résine photosensible à l'étape c) est supérieure à la hauteur des microfils ou nanofils.

Selon un mode de réalisation, l'épaisseur de la couche isolante est comprise entre 5 nm et 1 µm.

Selon un mode de réalisation, la gravure au plasma est une gravure au plasma d'oxygène.

Selon un mode de réalisation, la couche opaque est en un métal ou en un alliage métallique.

Selon un mode de réalisation, l'épaisseur de la couche opaque est comprise entre 5 nm et 1 µm.

Selon un mode de réalisation, le procédé comprend, en outre, les étapes successives suivantes après l'étape i) :
j) former une coque sur la portion de chaque microfil ou nanofil non recouverte de la couche isolante, la coque comprenant une région active adaptée à capter ou à émettre la majorité du rayonnement fourni ou capté par le dispositif électronique ;
k) former une couche d'électrode sur les coques et sur la couche isolante ;
1) recouvrir la couche d'électrode d'une couche conductrice ;
m) déposer une deuxième couche de résine photosensible s'étendant sur la couche conductrice entre les fils ;
n) délimiter dans la deuxième couche de résine, par photolithographie, un bloc de résine s'étendant entre les microfils ou nanofils ;
o) graver le bloc de résine sur une troisième épaisseur par gravure au plasma ;
p) graver la partie de la deuxième couche conductrice et réfléchissante non recouverte du bloc de résine photosensible restant après l'étape o) ; et
q) retirer la deuxième couche de résine photosensible restante après l'étape o).

Selon un mode de réalisation, l'étape n) comprend les étapes suivantes :
r) insoler partiellement la deuxième couche de résine photosensible sur une quatrième épaisseur ;
s) insoler des portions de la deuxième couche de résine photosensible sur toute son épaisseur en utilisant un écran occultant ; et
t) graver les portions de la deuxième couche de résine photosensible insolées aux étapes r) et s).

Selon un mode de réalisation, la couche conductrice est réfléchissante.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une coupe, partielle et schématique, d'un mode de réalisation d'un dispositif optoélectronique à microfils ou nanofils ; et
les figures 2A à 2P sont des coupes, partielles et schématiques, des structures obtenues à des étapes successives d'un mode de réalisation selon l'invention d'un procédé de fabrication du dispositif optoélectronique de la figure 1.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de polarisation et de commande du dispositif optoélectronique sont bien connus et ne sont pas décrits. Dans la suite de la description, sauf indication contraire, les termes "sensiblement", "environ" et "de l'ordre de" signifient "à 10 % près", de préférence à 5 % près.

La présente demande concerne notamment des dispositifs électroniques à structure tridimensionnelle comprenant des éléments tridimensionnels, par exemple des microfils, des nanofils, des éléments coniques ou des éléments tronconiques. En particulier, un élément conique ou tronconique peut être un élément conique ou tronconique de révolution ou un élément conique ou tronconique pyramidal. Dans la suite de la description, des modes de réalisation sont notamment décrits pour des dispositifs électroniques à structure tridimensionnelle à microfils ou à nanofils. Toutefois, ces modes de réalisation peuvent être mis en oeuvre pour des éléments tridimensionnels autres que des microfils ou des nanofils, par exemple des éléments tridimensionnels coniques ou tronconiques.

Le terme "microfil", "nanofil", "élément conique" ou "élément tronconique" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant supérieure ou égale à 1 fois, de préférence supérieure ou égale à 5 fois et encore plus préférentiellement supérieure ou égale à 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 800 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

Dans la suite de la description, des modes de réalisation vont être décrits dans le cas d'un dispositif optoélectronique à diodes électroluminescentes. Toutefois, il est clair que ces modes de réalisation peuvent concerner d'autres applications, notamment des dispositifs dédiés à la détection ou la mesure d'un rayonnement électromagnétique ou des dispositifs dédiés aux applications photovoltaïques.

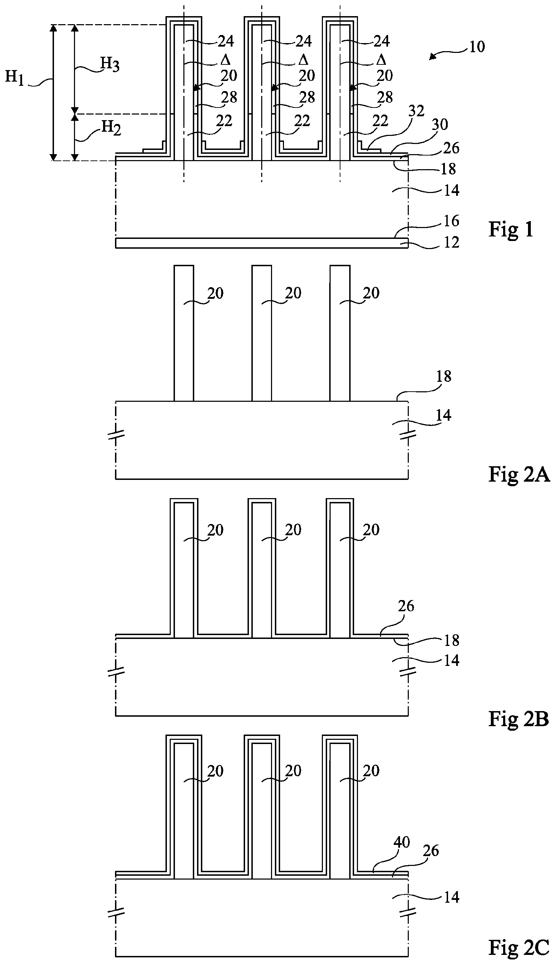

La figure 1 est une coupe, partielle et schématique, d'un dispositif optoélectronique 10 réalisé à partir de fils tels que décrits précédemment et adapté à l'émission d'un rayonnement électromagnétique.

Le dispositif 10 comprend, du bas vers le haut en figure 1 :
une première électrode de polarisation 12 ;
un substrat 14, par exemple semiconducteur, comprenant des faces parallèles 16 et 18, la face 16 étant au contact de l'électrode 12 et la face 18 pouvant être traitée de façon à favoriser la croissance de fils de façon organisée, ce traitement pouvant comprendre la formation d'une couche, non représentée, en surface du substrat 14 ;
des fils 20 d'axe Δ (trois fils étant représentés), de hauteur H₁, chaque fil comprenant une portion inférieure 22 de hauteur H₂, en contact avec la face 18, et une portion supérieure 24 de hauteur H₃ ;
une couche isolante 26 recouvrant la périphérie d'une partie de chaque portion inférieure 22 et recouvrant le substrat 14 entre les fils 20 ;
une coque 28 recouvrant chaque portion supérieure 24 ;
une couche de seconde électrode 30 recouvrant les coques 28 et la couche isolante 26 ; et
une portion conductrice 32 recouvrant la couche de seconde électrode 30 entre les fils 20, et s'étendant éventuellement sur une partie de la portion inférieure 22 de chaque fil 20, mais ne s'étendant pas sur la portion supérieure 24 de chaque fil 20.

Chaque fil 20 est, au moins en partie, formé à partir d'au moins un matériau semiconducteur. Selon un mode de réalisation, le matériau semiconducteur est choisi parmi le groupe comprenant les composés III-V, les composés II-VI ou les semiconducteurs ou composés du groupe IV.

L'ensemble formé par chaque fil 20 et la coque 28 associée constitue une diode électroluminescente. La coque 28 comprend notamment une zone active qui est la couche depuis laquelle est émise la majorité du rayonnement électromagnétique fourni par la diode électroluminescente. Selon un exemple, la zone active peut comporter des moyens de confinement tels que des puits quantiques multiples. Dans le présent mode de réalisation, au moins certaines diodes électroluminescentes sont à électrodes communes et lorsqu'une tension est appliquée entre les électrodes 12 et 30, un rayonnement lumineux est émis par les zones actives de ces diodes électroluminescentes.

Les diodes électroluminescentes du dispositif optoélectronique 10 peuvent être réparties selon un ensemble, deux ensembles ou plus de deux ensembles de diodes électroluminescentes. Chaque ensemble peut comprendre de quelques diodes électroluminescentes à plusieurs millions de diodes électroluminescentes.

Dans le présent mode de réalisation, la couche isolante 26 permet de délimiter la coque 28 pour chaque fil 20 et fournit une isolation électrique entre la couche d'électrode 30 et le substrat 14.

Dans le présent mode de réalisation, la portion conductrice 32 permet, de façon avantageuse, de diminuer la résistance de la couche d'électrode 30. De préférence, la portion conductrice 32 est réfléchissante et permet, de façon avantageuse, d'augmenter la proportion du rayonnement émis par les diodes électroluminescentes qui s'échappe du dispositif optoélectronique 10.

Les figures 2A à 2P sont des coupes, partielles et schématiques, des structures obtenues à des étapes successives d'un mode de réalisation d'un procédé de fabrication du dispositif optoélectronique 10 représenté en figure 1.

La figure 2A représente la structure obtenue après avoir fait croître les fils 20 sur le substrat 14.

Le substrat 14 peut correspondre à une structure monobloc ou correspondre à une couche recouvrant un support constitué d'un autre matériau. Le substrat 14 est de préférence un substrat semiconducteur, par exemple un substrat en silicium, en germanium, en carbure de silicium, en un composé III-V, tel que du GaN ou du GaAs, ou un substrat en ZnO, ou un substrat conducteur, par exemple un substrat en un métal ou un alliage métallique, notamment le cuivre, le titane, le molybdène et l'acier. De préférence, le substrat 14 est un substrat de silicium monocristallin. De préférence, il s'agit d'un substrat semiconducteur compatible avec les procédés de fabrication mis en oeuvre en microélectronique. Le substrat 14 peut correspondre à une structure multicouches de type silicium sur isolant, également appelée SOI (acronyme anglais pour Silicon On Insulator). Dans ce cas, l'électrode 12 peut être réalisée du côté de la face 18 du substrat 14. Le substrat 14 peut être fortement dopé, faiblement dopé ou non dopé.

Un traitement préalable du substrat 14 pour favoriser la croissance de fils 20 à des emplacements privilégiés peut être prévu. Le traitement appliqué au substrat pour favoriser la croissance de fils peut correspondre à l'un des traitements décrits dans les documents US 7 829 443, FR 2 995 729 ou FR 2 997 558.

Les fils 20 peuvent être, au moins en partie, formés à partir de matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les fils 20 peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments dans le composé II-VI peuvent être combinés avec différentes fractions molaires.

Les fils 20 peuvent être, au moins en partie, formés à partir de matériaux semiconducteurs comportant majoritairement au moins un élément du groupe IV. Des exemples de matériaux semiconducteurs du groupe IV sont le silicium (Si), le carbone (C), le germanium (Ge), les alliages de carbure de silicium (SiC), les alliages silicium-germanium (SiGe) ou les alliages de carbure de germanium (GeC).

La hauteur H₁ de chaque fil 20 peut être comprise entre 250 nm et 50 µm, de préférence entre 1 µm et 20 µm. Chaque fil 20 peut avoir une structure semiconductrice allongée selon un axe sensiblement perpendiculaire à la face 18. Chaque fil 20 peut avoir une forme générale cylindrique. Les axes de deux fils 20 adjacents peuvent être distants de 0,5 µm à 20 µm et de préférence de 3 µm à 20 µm. A titre d'exemple, les fils 20 peuvent être régulièrement répartis, notamment selon un réseau hexagonal ou carré.

La section droite des fils 20 peut avoir différentes formes, telles que, par exemple, une forme ovale, circulaire ou polygonale, notamment triangulaire, rectangulaire, carrée ou hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil. Le diamètre moyen de chaque fil 20 peut être compris entre 50 nm et 10 µm, de préférence entre 200 nm et 10 µm.

Le procédé de croissance des fils peut être un procédé du type dépôt chimique en phase vapeur (CVD, sigle anglais pour Chemical Vapor Déposition) ou dépôt chimique en phase vapeur organométallique (MOCVD, acronyme anglais pour Metal-Organic Chemical Vapor Déposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy) ou l'épitaxie en phase vapeur aux hydrures (HVPE, acronyme anglais pour Hydride Vapor Phase Epitaxy) peuvent être utilisés. De plus, des procédés électrochimiques peuvent également être utilisés, par exemple, le dépôt en bain chimique (CBD, sigle anglais pour Chemical Bath Déposition), les procédés hydrothermiques (également appelés procédés hydrothermaux), la pyrolise d'aérosol liquide ou l'électrodépôt.

A titre d'exemple, le procédé peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphoshine (TBP), l'arsine (AsH₃) ou le diméthylhydrazine (UDMH).

La figure 2B représente la structure obtenue après avoir déposé la couche isolante 26 sur la totalité des fils 20 et sur la face 18 entre les fils. La couche isolante 26 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (notamment de formule générale SiOₓN_{y}, par exemple du Si₂ON₂), en oxyde d'hafnium (HfO₂), en oxyde d'aluminium (Al₂O₃) ou en diamant. A titre d'exemple, l'épaisseur de la couche isolante 26 est comprise entre 5 nm et 1 µm, de préférence entre 10 nm et 500 nm, par exemple égale à environ 300 nm. La couche isolante 26 peut être déposée à titre d'exemple par dépôt chimique en phase vapeur assisté par plasma (PECVD, sigle anglais pour Plasma-Enhanced Chemical Vapor Déposition), dépôt chimique en phase vapeur à basse pression (LPCVD, sigle anglais pour Low-Pressure Chemical Vapor Déposition), dépôt chimique en phase vapeur à pression sous-atmosphérique (SACVD, sigle anglais pour Sub-Atmospheric Chemical Vapor Déposition), CVD, dépôt physique en phase vapeur (PVD, sigle anglais pour Physical Vapor Déposition), ou dépôt de couche atomique (ALD, sigle anglais pour Atomic Layer Déposition).

La figure 2C représente la structure obtenue après avoir déposé une couche opaque 40 sur la couche isolante 26. La couche opaque 40 peut être en un métal ou en un alliage métallique, par exemple de l'aluminium (Al), du titane (Ti), du cuivre (Cu), un alliage d'aluminium et de silicium, ou du tungstène (W). L'épaisseur de la couche opaque 40 peut être comprise entre 50 nm et 1 µm, de préférence entre 100 nm et 200 nm, par exemple égale à environ 150 nm. La couche opaque 40 est, à titre d'exemple, déposée par PVD, CVD ou ALD.

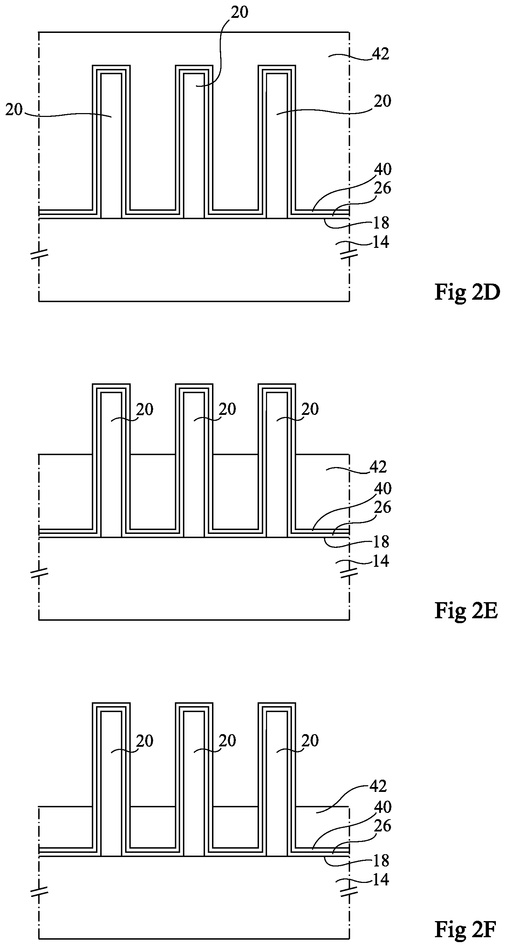

La figure 2D représente la structure obtenue après avoir déposé une couche 42 d'une résine photosensible sur l'ensemble de la structure. La couche de résine 42 est notamment présente entre les fils 20. L'épaisseur maximale de la couche de résine 42 est supérieure à la hauteur H₁ des fils 20. L'épaisseur maximale de la couche de résine 42 est comprise entre 250 nm et 50 µm.

La figure 2E représente la structure obtenue après une première étape de gravure partielle de la couche de résine 42 dans laquelle seule une portion supérieure de la couche de résine 42 est retirée. L'épaisseur retirée de la couche de résine 42 après la première étape de gravure peut être de quelques micromètres. La première étape de gravure est, de préférence, une étape de photolithographie comprenant une étape d'insolation de la couche de résine 42, par exemple par exposition de la couche de résine 42 à un rayonnement ultraviolet, et une étape de développement de la couche de résine dans laquelle une partie de la couche de résine est retirée, par exemple par gravure par voie liquide en mettant la résine au contact d'un révélateur. La résine photosensible peut être une résine photosensible positive, c'est-à-dire que la partie de la résine photosensible exposée à un rayonnement adapté devient soluble au révélateur et la partie de résine photosensible non exposée reste insoluble. Une insolation et un développement partiels de la résine, notamment par ajustement de l'énergie d'insolation et/ou de la durée d'insolation, peuvent alors être mis en oeuvre. L'énergie du rayonnement peut être comprise par exemple entre 20 et 100 mW/cm2. La durée d'insolation est, par exemple, comprise entre quelques secondes et une centaine de secondes. La résine photosensible peut être une résine photosensible négative, c'est-à-dire que la partie de la résine photosensible exposée à un rayonnement adapté devient insoluble au révélateur et la partie de résine photosensible non exposée reste soluble. Dans ce cas, un développement partiel de la résine par ajustement de la durée de développement peut être mis en oeuvre sans exposition de la résine ou avec une exposition post-développement.

Selon un mode de réalisation, les fils 20 peuvent être au moins en partie transparents. La présence de la couche opaque 40 permet alors de réduire, voire de supprimer, le guidage du rayonnement d'insolation par les fils 20, ce qui peut entraîner une surexposition indésirable de régions de la couche de résine 42 autour des fils 20.

La figure 2F représente la structure obtenue après une deuxième étape de gravure de la couche de résine 42 dans laquelle la couche de résine 42 est à nouveau gravée de façon partielle, seule une portion supérieure de la couche de résine 42 obtenue à l'issue de l'étape précédente étant retirée. L'épaisseur retirée de la couche de résine 42 après la deuxième étape de gravure peut être de quelques centaines de nanomètres à quelques micromètres. La deuxième étape de gravure est, de préférence, une étape de gravure utilisant un plasma à base d'oxygène.

Selon un mode de réalisation, il peut être utilisé pour le procédé de gravure au plasma selon l'invention toute source de gravure classique telle que des sources RIE (sigle anglais pour Reactive Ion Etching) et plasma haute densité, en particulier toute source de gravure du type utilisé pour la gravure des matériaux organiques. La puissance d'excitation peut être comprise entre 10 W à 1 kW. Le substrat peut être maintenu à la température ambiante, par exemple à 20°C.

L'utilisation d'une gravure au plasma permet, de façon avantageuse, d'atteindre la hauteur souhaitée, de façon précise et reproductible, pour la couche de résine 42. En outre, l'utilisation d'un plasma permet de nettoyer les surfaces exposées pour les étapes ultérieures, notamment en retirant les résidus organiques indésirables. Cela permet, en outre, d'éviter les effets parasites qui se produisent au cours de l'exposition d'une photolithographie en raison de la forme des fils et des couches présentes et entraînant notamment un rétrécissement des bandes de résine (en anglais notching).

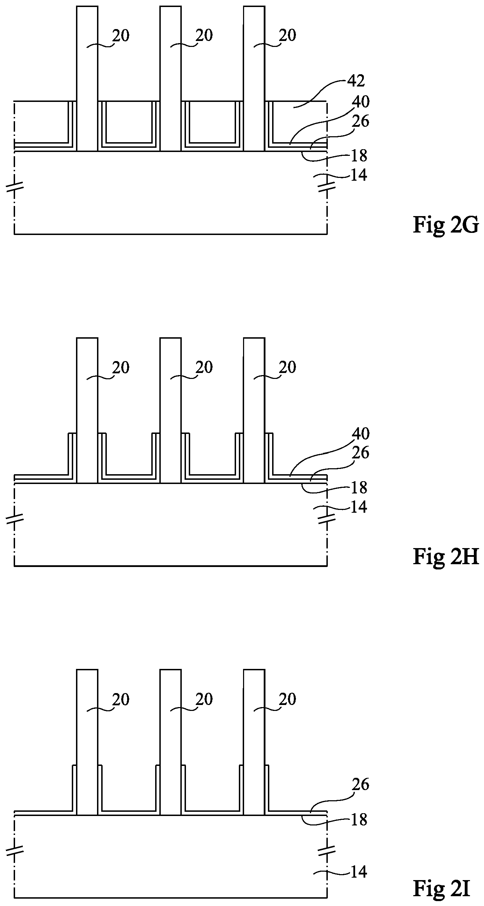

La figure 2G représente la structure obtenue après une étape de gravure de la portion de la couche opaque 40 non recouverte par la couche de résine 42 et une étape de gravure de la portion de la couche isolante 26 qui n'est alors plus recouverte par la couche opaque 40. La gravure de la couche opaque 40 peut être une gravure par voie humide ou sèche (gravure au plasma). La gravure de la couche isolante 26 peut être une gravure par voie humide ou sèche (gravure au plasma). De préférence, ces gravures sont sélectives par rapport à la résine.

La figure 2H représente la structure obtenue après une étape de retrait de la couche de résine restante. Le retrait de la couche de résine restante peut être réalisé par le trempage de la structure représentée en figure 2G dans un bain contenant un solvant adapté à dissoudre la couche de résine 42.

La figure 2I représente la structure obtenue après une étape de gravure de la couche opaque 40. La gravure peut être une gravure par voie humide ou sèche (gravure au plasma) et sélective par rapport aux fils 20 et par rapport à la couche 26.

Les étapes 2J à 2P qui vont être décrites sont adaptées pour la formation de la structure représentée en figure 1. De façon générale, les étapes ultérieures du procédé vont dépendre de l'application envisagée.

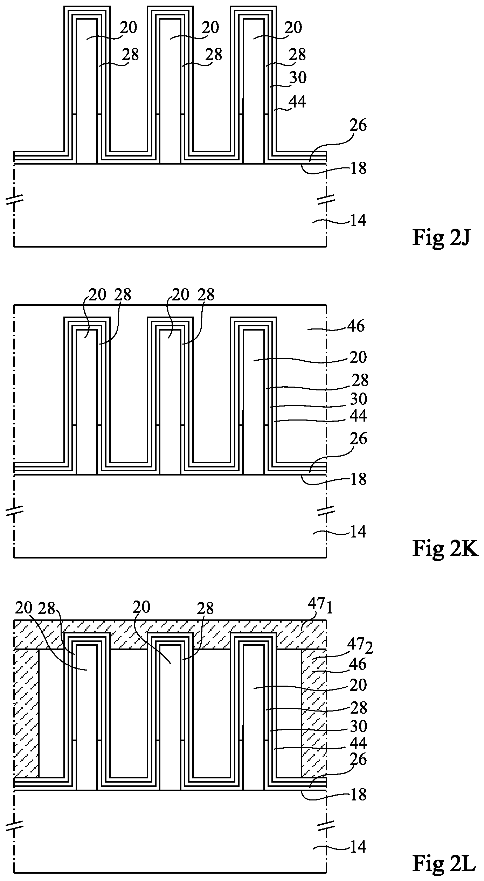

La figure 2J représente la structure obtenue après les étapes suivantes :
formation de la coque 28 pour chaque fil 20, par exemple par MOCVD ;
formation de la première électrode 30 par exemple par MOCVD, ALD, PVD, CVD ou PECVD ; et
formation d'une couche conductrice 44 recouvrant la première électrode 30, par exemple par PVD, ALD, CVD ou évaporation sous vide.

L'électrode 30 est adaptée à polariser la zone active de la coque 28 recouvrant chaque fil 20 et à laisser passer le rayonnement électromagnétique émis par les diodes électroluminescentes. Le matériau formant l'électrode 30 peut être un matériau transparent et conducteur tel que de l'oxyde d'indium-étain (ou ITO, acronyme anglais pour Indium Tin Oxide), de l'oxyde de zinc dopé ou non à l'aluminium, ou au gallium ou au bore, ou du graphène. A titre d'exemple, la couche d'électrode 30 a une épaisseur comprise entre 20 nm et 500 nm, de préférence entre 100 nm et 200 nm.

La couche conductrice 44 peut correspondre à une couche métallique, par exemple en aluminium, en argent, en cuivre, en or ou en ruthénium ou en un alliage d'au moins deux de ces composés. A titre d'exemple, la couche conductrice 44 a une épaisseur comprise entre 100 nm et 2000 nm. De préférence, la couche 44 est réfléchissante.

La figure 2K représente la structure obtenue après avoir déposé une couche 46 d'une résine photosensible sur l'ensemble de la structure. La couche de résine 46 est notamment présente entre les fils 20. L'épaisseur maximale de la couche de résine 46 est, de préférence, supérieure à la hauteur des fils 20 recouverts des coques 28, de la couche d'électrode 30 et de la couche conductrice 44. L'épaisseur maximale de la couche de résine 46 est comprise entre 250 nm et 50 µm. La couche de résine 46 peut avoir la même composition que la couche de résine 42.

La figure 2L représente la structure obtenue après une première insolation partielle de la couche de résine 46 dans laquelle seule une portion supérieure de la couche de résine 46 est exposée et une deuxième insolation partielle de la couche de résine 46, notamment en utilisant un écran occultant. Les deux étapes d'insolation conduisent à insoler la totalité de la couche de résine 46 à l'exception d'un bloc de résine 48 qui s'étend sur la couche 44 entre les fils 20 seulement sur une partie de la hauteur des fils 20. En figure 2L, on a représenté par une zone hachurée 47₁ la portion supérieure de la couche de résine 46 exposée lors de la première étape d'insolation et on a représenté par une zone hachurée 47₂ la portion supplémentaire de la couche de résine 46 exposée lors de la deuxième étape d'insolation.

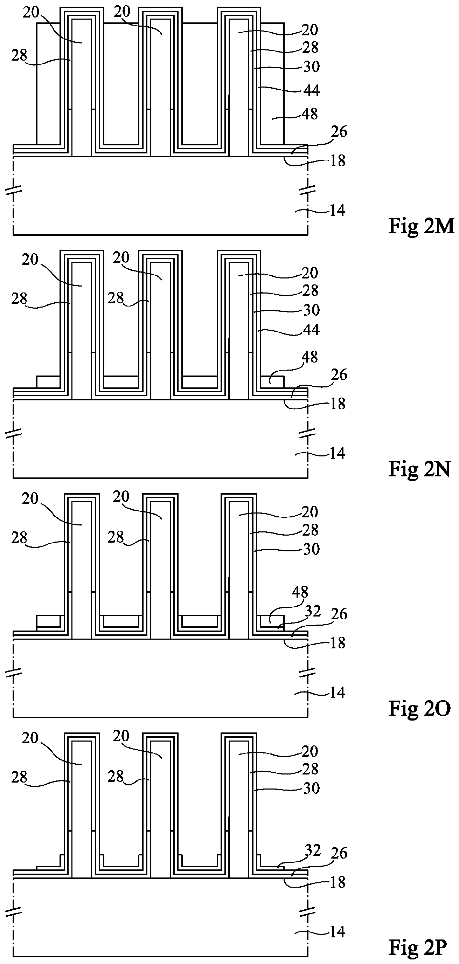

La figure 2M représente la structure obtenue après une étape de gravure qui conduit à l'obtention du bloc de résine 48. La gravure est, de préférence, une étape de développement de la couche de résine 46 d'un procédé de photolithographie.

La figure 2N représente la structure obtenue après une deuxième étape de gravure du bloc de résine 48 dans laquelle seule une portion supérieure du bloc de résine 48 est retirée. Cette étape peut être réalisée par une gravure au plasma comme cela a été décrit précédemment en relation avec la figure 2F pour la deuxième étape de gravure de la couche de résine 42.

La figure 2O représente la structure obtenue après une étape de gravure de la portion de la couche conductrice 44 non recouverte par le bloc de résine 48. La portion conductrice 32 est ainsi obtenue. La gravure de la couche conductrice 44 peut être une gravure par voie humide ou sèche (gravure au plasma). De préférence, cette gravure est sélective par rapport à la résine et par rapport à la couche 30.

La figure 2P représente la structure obtenue après une étape de retrait du bloc de résine 48.

## Revendications

1. Procédé de fabrication d'un dispositif optoélectronique (10) comprenant un substrat (14) et des microfils ou nanofils (20) reposant sur le substrat, le procédé comprenant les étapes successives suivantes :
a) recouvrir les microfils ou nanofils d'une couche isolante (26) ;
b) recouvrir la couche isolante d'une couche opaque (40) à un rayonnement ;
c) déposer une première couche de résine photosensible (42) s'étendant sur le substrat entre les fils ;
d) graver la première couche de résine photosensible sur une première épaisseur par photolithographie en insolant la première couche de résine photosensible avec ledit rayonnement ;
e) graver la première couche de résine photosensible restante après l'étape d) sur une deuxième épaisseur par gravure au plasma ;
f) graver la partie de la couche opaque non recouverte de la première couche de résine photosensible restante après l'étape e) ;
g) graver la partie de la couche isolante non recouverte de la couche opaque ;
h) retirer la première couche de résine photosensible restante après l'étape e) ; et
i) retirer la couche opaque.

2. Procédé selon la revendication 1, dans lequel la hauteur des microfils ou nanofils (20) est comprise entre 250 nm et 50 µm.

3. Procédé selon la revendication 1 ou 2, dans lequel l'épaisseur maximale de la première couche de résine photosensible (42) à l'étape c) est supérieure à la hauteur des microfils ou nanofils (20).

4. Procédé selon l'une quelconque des revendications 1 à 3, dans lequel l'épaisseur de la couche isolante (26) est comprise entre 5 nm et 1 µm.

5. Procédé selon l'une quelconque des revendications 1 à 4, dans lequel la gravure au plasma est une gravure au plasma d'oxygène.

6. Procédé selon l'une quelconque des revendications 1 à 5, dans lequel la couche opaque (40) est en un métal ou en un alliage métallique.

7. Procédé selon l'une quelconque des revendications 1 à 6, dans lequel l'épaisseur de la couche opaque (40) est comprise entre 5 nm et 1 µm.

8. Procédé selon l'une quelconque des revendications 1 à 7, comprenant, en outre, les étapes successives suivantes après l'étape i) :
j) former une coque (28) sur la portion de chaque microfil ou nanofil (20) non recouverte de la couche isolante (26), la coque comprenant une région active adaptée à capter ou à émettre la majorité du rayonnement fourni ou capté par le dispositif optoélectronique ;
k) former une couche d'électrode (30) sur les coques et sur la couche isolante ;
1) recouvrir la couche d'électrode d'une couche conductrice (44) ;
m) déposer une deuxième couche de résine photosensible (46) s'étendant sur la couche conductrice entre les fils ;
n) délimiter dans la deuxième couche de résine, par photolithographie, un bloc de résine (48) s'étendant entre les microfils ou nanofils (20) ;
o) graver le bloc de résine sur une troisième épaisseur par gravure au plasma ;
p) graver la partie de la deuxième couche conductrice et réfléchissante non recouverte du bloc de résine photosensible restant après l'étape o) ; et
q) retirer la deuxième couche de résine photosensible restante après l'étape o).

9. Procédé selon la revendication 8, dans lequel l'étape n) comprend les étapes suivantes :
r) insoler partiellement la deuxième couche de résine photosensible (46) sur une quatrième épaisseur ;
s) insoler des portions de la deuxième couche de résine photosensible sur toute son épaisseur en utilisant un écran occultant ; et
t) graver les portions de la deuxième couche de résine photosensible insolées aux étapes r) et s).

10. Procédé selon la revendication 8 ou 9, dans lequel la couche conductrice (44) est réfléchissante.

## Patentansprüche

1. Verfahren zur Herstellung einer optoelektronischen Vorrichtung (10), die ein Substrat (14) und Mikrodrähte oder Nanodrähte (20), die auf dem Substrat aufliegen, aufweist, wobei das Verfahren die folgenden aufeinanderfolgenden Schritte aufweist:
a) Abdecken der Mikrodrähte oder Nanodrähte mit einer Isolierschicht (26);
b) Abdecken der Isolierschicht mit einer Schicht (40), die opak für eine Strahlung ist;
c) Abscheiden einer ersten Resistschicht (42), die sich auf dem Substrat zwischen den Drähten erstreckt;
d) Ätzen der ersten Resistschicht über eine erste Dicke durch Fotolithographie durch Belichten der ersten Resistschicht mit der Strahlung;
e) Ätzen der nach Schritt d) verbleibenden ersten Resistschicht über eine zweite Dicke durch Plasmaätzen;
f) Ätzen des Teils der opaken Schicht, die nicht mit der ersten nach Schritt e) verbleibenden Resistschicht abgedeckt ist;
g) Ätzen des Teils der Isolierschicht, die nicht mit der opaken Schicht abgedeckt ist;
h) Entfernen der nach dem Schritt e) verbleibenden ersten Resistschicht; und
i) Entfernen der opaken Schicht.

2. Verfahren nach Anspruch 1, wobei die Höhe der Mikrodrähte oder Nanodrähte (20) in dem Bereich zwischen 250 nm und 50 µm liegt.

3. Verfahren nach Anspruch 1 oder 2, wobei die maximale Dicke der ersten Resistschicht (42) in Schritt c) größer als die Höhe der Mikrodrähte oder Nanodrähte (20) ist.

4. Verfahren nach einem der Ansprüche 1 bis 3, wobei die Dicke der Isolierschicht (26) in dem Bereich zwischen 5 nm und 1 µm liegt.

5. Verfahren nach einem der Ansprüche 1 bis 4, wobei das Plasmaätzen ein Sauerstoffplasma-Ätzen ist.

6. Verfahren nach einem der Ansprüche 1 bis 5, wobei die opake Schicht (40) aus einem Metall oder einer Metalllegierung hergestellt ist.

7. Verfahren nach einem der Ansprüche 1 bis 6, wobei die Dicke der opaken Schicht (40) zwischen 5 nm und 1 µm liegt.

8. Verfahren nach einem der Ansprüche 1 bis 7, das ferner nach Schritt i) die folgenden aufeinanderfolgenden Schritte aufweist:
j) Bilden einer Hülle (28) auf dem Teil von jedem Mikrodraht oder Nanodraht (20), der nicht mit der Isolierschicht (26) abgedeckt ist, wobei die Hülle einen aktiven Bereich aufweist, der geeignet ist, den Großteil der von der optoelektronischen Vorrichtung gelieferten oder eingefangenen Strahlung einzufangen oder zu emittieren;
k) Bilden einer Elektrodenschicht (30) auf den Hüllen und auf der Isolierschicht;
l) Abdecken der Elektrodenschicht mit einer leitenden Schicht (44);
m) Abscheiden einer zweiten Resistschicht (46), die sich auf der leitenden Schicht zwischen den Drähten erstreckt;
n) Abgrenzen eines Resistblocks (48), der sich zwischen den Mikrodrähten oder Nanodrähten (20) erstreckt, in der zweiten Resistschicht durch Fotolithographie;
o) Ätzen des Resists über eine dritte Dicke durch Plasmaätzen;
p) Ätzen des Teils der zweiten reflektierenden leitenden Schicht, die nicht mit dem nach Schritt o) verbleibenden Resitblock abgedeckt ist; und
q) Entfernen der nach Schritt o) verbleibenden zweiten Resistschicht.

9. Verfahren nach Anspruch 8, wobei der Schritt n) die folgenden Schritte aufweist:
r) teilweises Belichten der zweiten Resistschicht (46) über eine vierte Dicke;
s) Belichten von Teilen der zweiten Resistschicht über deren gesamten Dicke durch Verwenden eines Maskenschirms; und
t) Ätzen der Teile der im Schritt r) und s) belichteten zweiten Resistschicht.

10. Verfahren nach Anspruch 8 oder 9, wobei die leitende Schicht (44) reflektierend ist.

## Claims

1. A method of manufacturing an optoelectronic device (10) comprising a substrate (14) and microwires or nanowires (20) resting on the substrate, the method comprising the successive steps of:
a) covering the microwires or nanowires with an insulating layer (26);
b) covering the insulating layer with a layer (40) opaque to a radiation;
c) depositing a first resist layer (42) extending on the substrate between the wires;
d) etching the first resist layer across a first thickness by photolithography by illuminating the first resist layer with said radiation;
e) etching the first resist layer remaining after step d) across a second thickness by plasma etching;
f) etching the portion of the opaque layer which is not covered with the first resist layer remaining after step e);
g) etching the portion of the insulating layer which is not covered with the opaque layer;
h) removing the first resist layer remaining after step e); and
i) removing the opaque layer.

2. The method of claim 1, wherein the height of the microwires or nanowires (20) is in the range from 250 nm to 50 µm.

3. The method of claim 1 or 2, wherein the maximum thickness of the first resist layer (42) at step c) is greater than the height of the microwires or nanowires (20).

4. The method of any of claims 1 to 3, wherein the thickness of the insulating layer (26) is in the range from 5 nm to 1 µm.

5. The method of any of claims 1 to 4, wherein the plasma etching is an oxygen plasma etching.

6. The method of any of claims 1 to 5, wherein the opaque layer (40) is made of a metal or of a metal alloy.

7. The method of any of claims 1 to 6, wherein the thickness of the opaque layer (40) is in the range from 5 nm to 1 µm.

8. The method of any of claims 1 to 7, further comprising, after step i), the successive steps of:
j) forming a shell (28) on the portion of each microwire or nanowire (20) which is not covered with the insulating layer (26), the shell comprising an active region capable of capturing or of emitting most of the radiation supplied or captured by the optoelectronic device;
k) forming an electrode layer (30) on the shells and on the insulating layer;
l) covering the electrode layer with a conductive layer (44);
m) depositing a second resist layer (46) extending on the conductive layer between the wires;
n) delimiting in the second resist layer, by photolithography, a resist block (48) extending between the microwires or nanowires (20);
o) etching the resist across a third thickness by plasma etching;
p) etching the portion of the second reflective conductive layer which is not covered with the resist block remaining after step o); and
q) removing the second resist layer remaining after step o).

9. The method of claim 8, wherein step n) comprises the steps of:
r) partially illuminating the second resist layer (46) across a fourth thickness;
s) illuminating portions of the second resist layer across its entire thickness by using a masking screen; and
t) etching the portions of the second resist layer illuminated at steps r) and s).

10. The method of claim 8 or 9, wherein the conductive layer (44) is reflective.
